# EUROPEAN PATENT SPECIFICATION

(11) **EP 3 012 863 B1**
(45) Date of publication and mention of the grant of the patent: **30.12.2020**
(21) Application number: 15163656.0
(22) Date of filing: 15.04.2015
(51) Int. Cl.: H01L 27/146, H01L 27/30, H01L 51/44

(54) **IMAGE SENSOR AND ELECTRONIC DEVICE INCLUDING THE SAME**
BILDSENSOR UND ELEKTRONISCHE VORRICHTUNG DAMIT
CAPTEUR D'IMAGE ET DISPOSITIF ÉLECTRONIQUE COMPRENANT CELUI-CI

(30) Priority: 30.09.2014 KR 20140131051
(43) Date of publication of application: 27.04.2016
(73) Proprietor: Samsung Electronics Co., Ltd., Gyeonggi-do 443-742 (KR)
(72) Inventor: Lee, Gae Hwang, Gyeonggi-do (KR); Lee, Kwang Hee, Gyeonggi-do (KR); Leem, Dong-Seok, Gyeonggi-do (KR); Jin, Yong Wan, Seoul (KR)
(74) Representative: Elkington and Fife LLP

(56) References cited:
- EP-A1- 2 770 550
- US-A1- 2010 176 473
- US-A1- 2011 128 423
- US-A1- 2011 164 156
- US-A1- 2012 248 561
- US-A1- 2013 099 343
- US-A1- 2014 021 574

## Description

### Field of Invention

Example embodiments relate to an image sensor and an electronic device including the same.

### Background of the Invention

A photoelectronic device converts light into an electrical signal using photoelectronic effects, and may include a photodiode and/or a phototransistor. The photoelectronic device may be applied to an image sensor and/or a solar cell.

An image sensor including a photodiode requires relatively high resolution and thus a relatively small pixel. At present, a silicon photodiode is widely used, but the silicon photodiode has a problem of deteriorated sensitivity and has a relatively small absorption area due to relatively small pixels.

On the other hand, a color filter selectively absorbs light in a given (or alternatively, predetermined) wavelength region in each pixel when light enters an image sensor. A red filter, a blue filter, and a green filter are respectively disposed on a red pixel, a blue pixel, and a green pixel and selectively absorb red, blue, and green light, and the selectively absorbed light may be transferred to a photodiode of each pixel.

However, the color filters may not only absorb light by themselves, and thus bring about loss of a relatively large amount of light delivered to the photodiode, but are also formed through a process of spin coating, UV exposure, and/or wet etching, and thus have a limitation of reducing the pixel size of an image sensor to less than or equal to a given (or alternatively, predetermined) size.

US 2010/0176473 teaches an imaging photodetection device in which a plurality of transparent sections are embedded in a low refractive index transparent layer to cause diffraction to improve light utilization.

US2011/0128423 teaches an image sensor with an infra-red filter and colour filters formed on the colour sensors.

A solid state image sensor with a dispersive element array is taught by US 2011/0164156.

An image sensor with a complex optical arrangement is taught by US2014/0021574

An organic photoelectronic device is taught by EP 2 770 550.

### Summary of the Invention

Example embodiments provide an image sensor capable of increasing wavelength selectivity of each pixel, thus improving sensitivity and photo-efficiency as well as reducing the pixel size to less than or equal to a given (or alternatively, predetermined) size.

Example embodiments also provide an electronic device including the image sensor.

According to a first aspect of the invention there is provided an image sensor according to claim 1.

The image sensor may further include an organic photoelectronic device on the nanopattern layer, the organic photoelectronic device including a first electrode and a second electrode facing each other, and an organic photoelectric conversion layer between the first electrode and the second electrode.
layer between the first electrode and the second electrode.

The organic photoelectric conversion layer may absorb light in a third wavelength region different from the first wavelength region and the second wavelength region.

The first wavelength region may be a blue wavelength region, the second wavelength region may be a red wavelength region, and the third wavelength region may be a green wavelength region.

The red wavelength region may have a maximum absorption wavelength (λₘₐₓ) of greater than about 580 nanometers and less than or equal to about 700 nanometers, the blue wavelength region may have a maximum absorption wavelength (λₘₐₓ) of greater than or equal to about 400 nanometers and less than about 500 nanometers, and the green wavelength region may have a maximum absorption wavelength (λₘₐₓ) of about 500 nanometers to about 580 nanometers.

The first photo-sensing device and the second photo-sensing device may be positioned at different depths from the surface of the semiconductor substrate.

The first photo-sensing device may sense light in a longer wavelength region than the second photo-sensing device, and the first photo-sensing device may be further from the surface of the semiconductor substrate than the second photo-sensing device.

The first photo-sensing device and the second photo-sensing device may be sequentially stacked in a vertical direction.

The plurality of nanopatterns may selectively reflect light in the third wavelength region to the organic photoelectric conversion layer.

The organic photoelectric conversion layer may include a p-type semiconductor and an n-type semiconductor, and the p-type semiconductor and the n-type semiconductor form a pn junction.

According to example embodiments, an electronic device includes the image sensor.

Accordingly, an image sensor according to example embodiments may increase wavelength selectivity per pixel and thus improve sensitivity and photo-efficiency as well as reduce the pixel size to less than and equal to a given (or alternatively, predetermined) size.

### Brief Description of the Drawings

FIG. 1 is a cross-sectional view showing a CMOS image sensor according to example embodiments,
FIG. 2 is a cross-sectional view enlarging a region 'A' in FIG. 1,
FIG. 3 is a reference view showing a principle that a wavelength in a particular region is selected through a nanopattern applied to an image sensor according to example embodiments,
FIGS. 4(a) - 4(c) is a top plan view prefiguratively showing various nanopatterns applied to an image sensor according to example embodiments,
FIG. 5 is a top plan view showing one example of a nanopattern layer applied to an image sensor according to example embodiments,
FIG. 6 is the cross-sectional view of the nanopattern layer cut along an I-I line in FIG. 5,
FIG. 7 is a cross-sectional view showing a CMOS image sensor according to example embodiments,
FIG. 8 is a cross-sectional view enlarging a region 'B' in FIG. 7,
FIG. 9 is a cross-sectional view showing a CMOS image sensor according to example embodiments,
FIG. 10 is a cross-sectional view showing a part of the nanopattern layer according to Example 1,
FIGS. 11(a) and (b) show a blue electric field distribution chart (a) and a red electric field distribution chart (b) in a silicon (Si) photodiode including the nanopattern layer of Example 1 thereon,
FIG. 12 is a cross-sectional view showing a part of the nanopattern layer according to Example 2, and
FIGS. 13(a) and (b) show a blue electric field distribution chart (a) and a red electric field distribution chart (b) in a silicon (Si) photodiode including the nanopattern layer of Example 2 thereon.

### Detailed Description

Example embodiments will hereinafter be described in detail, and may be more easily performed by those who have common knowledge in the related art. However, this disclosure may be embodied in many different forms, and is not construed as limited to the example embodiments set forth herein.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

It will be understood that when an element or layer is referred to as being "on," "connected to," "coupled to," or "covering" another element or layer, it may be directly on, connected to, coupled to, or covering the other element or layer, or intervening elements or layers may be present. In contrast, when an element is referred to as being "directly on," "directly connected to," or "directly coupled to" another element or layer, there are no intervening elements or layers present. Like numbers refer to like elements throughout the specification. As used herein, the term "and/or" includes any and all combinations of one or more of the associated listed items.

It will be understood that, although the terms first, second, third, etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the example embodiments.

Spatially relative terms, e.g., "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" may encompass both an orientation of above and below. The device may be otherwise oriented (rotated 90 degrees or at other orientations) and the spatially relative descriptors used herein interpreted accordingly.

The terminology used herein is for the purpose of describing various embodiments only and is not intended to be limiting of the example embodiments. As used herein, the singular forms "a," "an," and "the" are intended to include the plural forms as well, unless the context clearly indicates otherwise. It will be further understood that the terms "comprises," "comprising," "includes," and/or "including," if used herein, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art. It will be further understood that terms, including those defined in commonly used dictionaries, should be interpreted as having a meaning that is consistent with their meaning in the context of the relevant art and will not be interpreted in an idealized or overly formal sense unless expressly so defined herein.

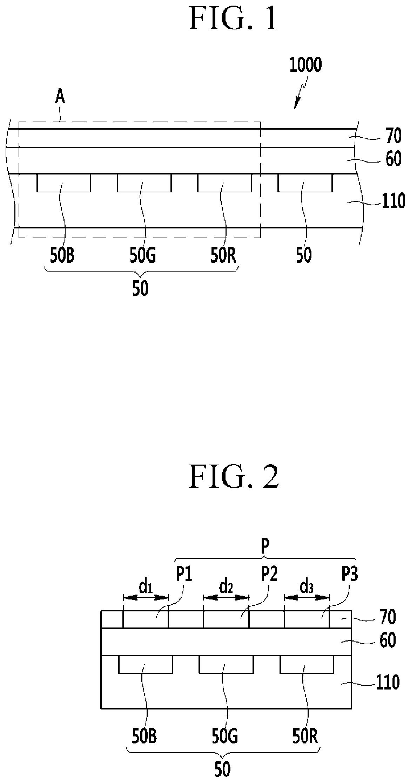

Referring to FIG. 1, a CMOS image sensor according to example embodiments will now be described.

FIG. 1 is a cross-sectional view showing a CMOS image sensor according to example embodiments.

Referring to FIG. 1, the CMOS image sensor 1000 according to example embodiments includes a semiconductor substrate 110 and a nanopattern layer 70 positioned on the semiconductor substrate 110.

The semiconductor substrate 110 may be a silicon substrate, for example, a monocrystalline silicon substrate. The semiconductor substrate 110 is integrated with a plurality of photo-sensing devices 50 and transmission transistor (not shown). The plurality of photo-sensing devices 50 may be photodiodes.

FIG. 1 shows a blue pixel, a green pixel, and a red pixel that are adjacent to each other, but it is not limited thereto. Hereinafter, a constituent element including "B" in the reference numeral refers to a constituent element included in the blue pixel, a constituent element including "G" in the reference numeral refers to a constituent element included in the green pixel, and a constituent element including "R" in the reference numeral refers to a constituent element included in the red pixel.

The photo-sensing device 50 and the transmission transistor may be integrated in each pixel, and for example, as shown in the drawing, the photo-sensing device 50 may include a photo-sensing device 50B of a blue pixel, a photo-sensing device 50G of a green pixel, and a photo-sensing device 50R of a red pixel. The photo-sensing device 50 senses light, and the information sensed by the photo-sensing device 50 may be transferred by the transmission transistor.

A metal wire (not shown) and a pad (not shown) are formed on the semiconductor substrate 110. In order to decrease signal delay, the metal wire and pad may be made of a metal having relatively low resistivity, for example, aluminum (Al), copper (Cu), silver (Ag), and alloys thereof, but are not limited thereto.

A lower insulation layer 60 is formed on the metal wire and the pad. The insulation layer 60 may be made of an inorganic insulating material (e.g., a silicon oxide and/or a silicon nitride), or a relatively low dielectric constant (low K) material (e.g., SiC, SiCOH, SiCO, and SiOF).

The lower insulation layer 60 has a trench (not shown) exposing the photo-sensing devices 50B, 50G, and 50R of each pixel. The trench may be filled with fillers.

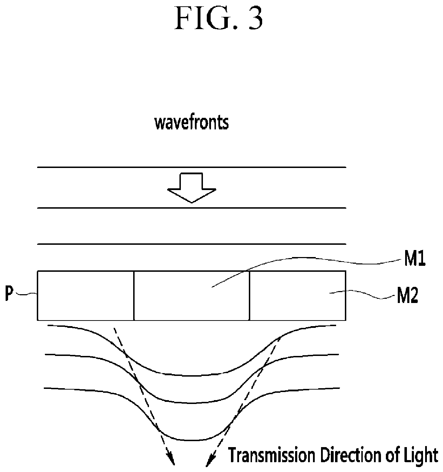

The nanopattern layer 70 having a plurality of nanopatterns is formed on the insulation layer 60. Each single nanopattern included in the plurality of nanopatterns corresponds to a photo-sensing device 50R, 50G, and 50B in a one-to-one manner, and includes at least two types of dielectric substances having different refractive indexes. This will be illustrated referring to FIGS. 2 and 3.

FIG. 2 is a cross-sectional view enlarging a region 'A' in FIG. 1.

Referring to FIG. 2, the nanopattern layer 70 having a plurality of nanopatterns P is formed on the semiconductor substrate 110 in which a plurality of photo-sensing devices 50 are integrated. Each nanopattern P1, P2, and P3 corresponds to each photo-sensing device 50B, 50G, and 50R.

The nanopattern P has a size of tens to hundreds of nanometers, and may have a similar size to, for example, that of a visible light wavelength region. Since the nanopattern having a similar size to that of the visible light wavelength region has higher coherency with visible light, and a transmitted wavelength region may be selected through shape control of the pattern, the nanopattern having a given (or alternatively, predetermined) size may selectively transmit a given (or alternatively, predetermined) wavelength region.

The nanopattern has a size (d1, d2, and d3) ranging from greater than or equal to about 1 nanometer to less than about 1 micrometer and may have a size ranging from greater than or equal to about 10 nanometers to less than about 1 micrometer, greater than or equal to about 100 nanometers and less than about 1 micrometer, or greater than or equal to about 150 nanometers to less than about 1 micrometer. Herein, the size of the nanopattern indicates the longest horizontal length (width) that one nanopattern has in the cross-section of the nanopattern layer 70 when horizontally cut. For example, when the nanopattern has a circular ring shape, the pattern size is a diameter of an outer circle.

FIG. 3 is a reference view showing a principle that a wavelength in a particular region is selected through a nanopattern applied to an image sensor according to example embodiments.

Referring to FIG. 3, wavefronts of incident light through the nanopattern P causes interference between two types of dielectric substances M1 and M2 consisting of the nanopattern P and having a different refractive index, and thus a wavelength in a particular region may pass the nanopattern (P). Herein, the dielectric substance indicates an insulator material becoming polarized in an electric field but not passing electricity. The two types of dielectric substances M1 and M2 have a refractive index difference of greater than or equal to 0.2.

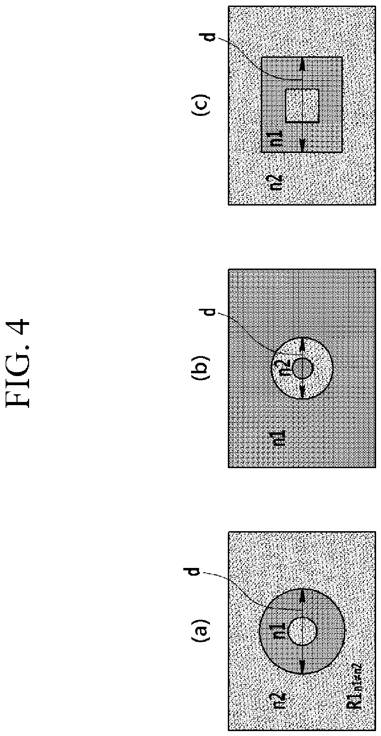

FIGS. 4(a) - 4(c) is a top plan view prefiguratively showing various nanopatterns applied to an image sensor according to example embodiments.

A nanopattern P shown in FIGS. 4(a) - 4(c) has a circular ring as shown in FIGS. 4(a) and 4(b) or a quadrangular ring as shown in FIG. 4(c), but the inventive concepts are not particularly limited to such a shape of a circle, a quadrangle, and a triangle. Referring to FIGS. 4(a) - 4(c), the nanopattern (P) is defined by an interface between two types of dielectric substances having different refractive indexes n1 and n2. Referring to FIG. 4(a), a circular ring region consists of a dielectric substance having a refractive index n1, while outer and inner regions forming an interface with the ring consist of a dielectric substance having a refractive index n2, but the circular ring region may consist of a dielectric substance having a refractive index n1, while an outer region forming an interface with the ring consists of a dielectric substance having a refractive index n2, and an inner region forming an interface with the ring consists of a dielectric substance having a refractive index n3 (n1#n2#n3).

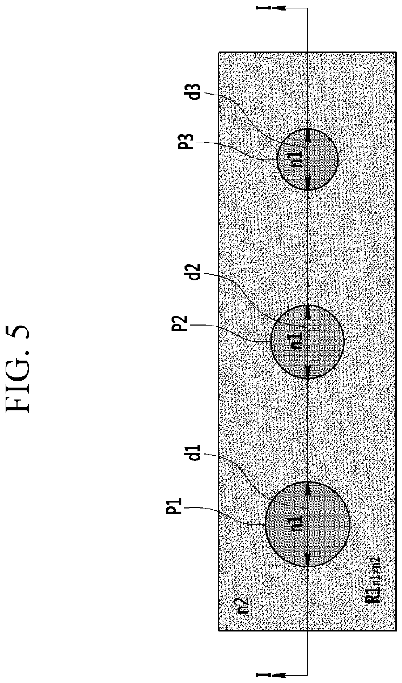

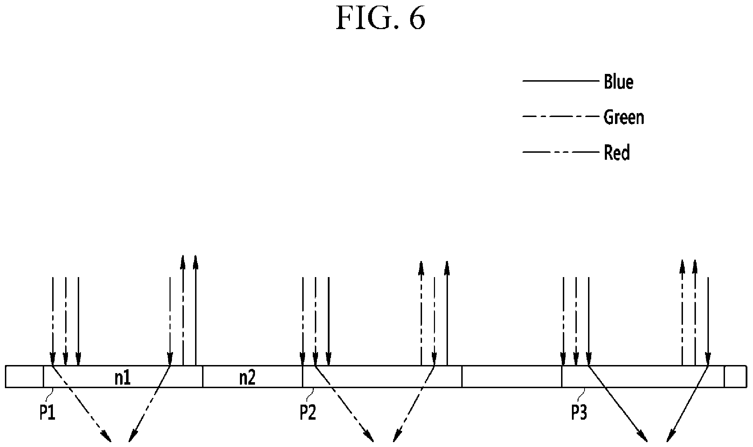

FIG. 5 is a top plan view showing one nanopattern layer applied to an image sensor according to example embodiments, and FIG. 6 is the cross-sectional view of the nanopattern layer cut along an I-I line in FIG. 5.

Referring to FIGS. 5 and 6, the nanopattern layer includes a plurality of nanopatterns P1, P2, and P3. The nanopattern layer includes two types of dielectric substances having different refractive indexes n1 and n2, and the two types of dielectric substances are positioned in different regions from each other. A plurality of nanopatterns may have the same or different sizes d1, d2, and d3 from one another. Referring to FIG. 6, a nanopattern having a given (or alternatively, predetermined) size selectively passes a given (or alternatively, predetermined) wavelength region (e.g., blue, green, or red wavelength regions) out of a visible ray area, and thus the size d1, d2 or d3 of a nanopattern may be selected depending on a transmitted wavelength region. For example, the size d1, d2, and d3 of the nanopattern may each be independently in a range of less than about 1 micrometer, greater than or equal to about 10 nanometers and less than about 1 micrometer, greater than or equal to about 100 nanometers and less than about 1 micrometer, or greater than or equal to about 150 nanometers to less than about 1 micrometer.

The image sensor may have relatively high color separation characteristics without equipping a separate organic color filter layer, due to the nanopattern layer having a nanopattern of a given (or alternatively, predetermined) size. For example, an organic color filter layer having a relatively large thickness may be omitted by introducing a nanopattern layer having a thickness of greater than or equal to about 50 nanometers to less than about 1 micrometer or about 200 nanometers to about 500 nanometers, and thus, a pixel size may be reduced. In addition, the nanopattern layer has characteristics of focusing light and thus may secure characteristics of concentrating light without using separate microlens.

Hereinafter, an image sensor according to example embodiments is described.

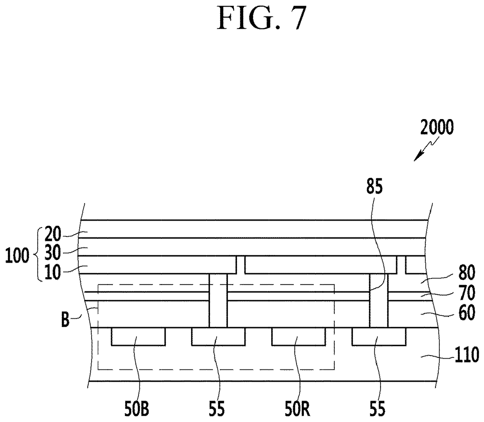

FIG. 7 is a cross-sectional view showing a CMOS image sensor according to example embodiments.

Referring to FIG. 7, the image sensor 2000 according to example embodiments includes a semiconductor substrate 110 and a nanopattern layer 70 positioned on the semiconductor substrate 110, like the example embodiment illustrated in FIG. 1.

The semiconductor substrate 110 may be a silicon substrate, for example, a monocrystalline silicon substrate. The semiconductor substrate 110 is integrated with a blue photo-sensing device 50B, a red photo-sensing device 50R, a charge storage device 55, and a transmission transistor (not shown). The blue photo-sensing device 50B and the red photo-sensing device 50R may be photodiodes.

The blue photo-sensing device 50B, the red photo-sensing device 50R, the transmission transistor, and/or the charge storage device 55 may be integrated in each pixel, and for example, as shown in the drawing, the blue photo-sensing device 50B may be included in a blue pixel and the red photo-sensing device 50R may be included in a red pixel. Even though the charge storage device 55 is drawn only in a green pixel, the blue pixel and the red pixel may respectively include a charge storage device connected with the blue photo-sensing device 50B and a charge storage device connected with the red photo-sensing device 50R.

The blue photo-sensing device 50B and the red photo-sensing device 50R sense light, the information sensed by the photo-sensing devices may be transferred by the transmission transistor, the charge storage device 55 of the green pixel is electrically connected with an organic photoelectronic device 100 that will be described later, and the information of the charge storage device 55 may be transferred by the transmission transistor.

A metal wire (not shown) and a pad (not shown) are formed on the semiconductor substrate 110. In order to decrease signal delay, the metal wire and pad may be made of a metal having relatively low resistivity, for example, aluminum (Al), copper (Cu), silver (Ag), and alloys thereof, but are not limited thereto. Further, it is not limited to the structure, and the metal wire and pad may be positioned under the photo-sensing devices 50B and 50R.

A lower insulation layer 60 is formed on the metal line and pad which is described like example embodiment illustrated in FIG. 6.

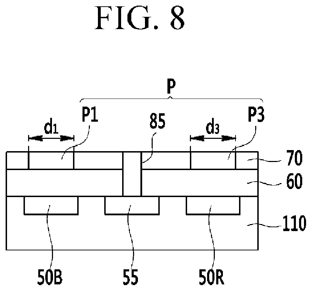

On the lower insulation layer 60, the nanopattern layer 70 having a plurality of nanopatterns is formed. A single nanopattern of the plurality of nanopatterns is positioned to correspond to a single photo-sensing device, for example, 50R and 50B, in a one-to-one manner. This will be illustrated referring to FIG. 8.

FIG. 8 is a cross-sectional view enlarging a region 'B' in FIG. 7.

Referring to FIG. 8, the nanopattern layer 70 having a plurality of nanopatterns P is formed on a semiconductor substrate in which the plurality of photo-sensing devices 50B and 50R are integrated. Each nanopattern P1 and P3 are positioned to correspond to each photo-sensing device 50B and 50R.

As described above, the nanopattern (P) has a size of tens to hundreds of nanometers, for example, a similar size to that of a visible light wavelength region. The nanopattern having a similar size to that of a visible light wavelength region has relatively high coherency with visible light, and thus a transmitted wavelength region to pass through may be selected by controlling the shape of the pattern.

The size d1 and d3 of the nanopatterns may be controlled depending on a transmitted wavelength region for transmittance. The size d1 and d3 of the nanopattern is in a range of greater than or equal to about 1 nanometer to less than about 1 micrometer and may be in a range of greater than or equal to about 10 nanometers to less than about 1 micrometer, greater than or equal to about 100 nanometers to less than about 1 micrometer, or greater than or equal to about 150 nanometers to less than about 1 micrometer.

Referring to FIG. 7, an upper insulation layer 80 is formed on the nanopattern layer 70. The upper insulation layer 80 and the lower insulation layer 60 have a contact hole (not shown) exposing the pad and a through-hole 85 exposing the charge storage device 55 of the green pixel.

The organic photoelectronic device 100 is formed on the upper insulation layer 80.

The organic photoelectronic device 100 includes a first electrode 10 and a second electrode 20, and an organic photoelectric conversion layer 30 interposed between the first electrode 10 and the second electrode 20.

The organic photoelectric conversion layer 30 may include, for example, a p-type semiconductor and an n-type semiconductor, and the p-type semiconductor and the n-type semiconductor may form a pn junction. At least one of the p-type semiconductor and the n-type semiconductor selectively absorbs light in a green wavelength region to generate excitons, and then the generated excitons may be separated into holes and electrons to provide a photoelectronic effect.

The p-type semiconductor material may be, for example, quinacridone or a derivative thereof, or subphthalocyanine or a derivative thereof, and the n-type semiconductor material may be, for example, a cyanovinyl group-containing thiophene derivative, subphthalocyanine or a derivative thereof, or fullerene or a fullerene derivative, but are not limited thereto.

The organic photoelectric conversion layer 30 may be a single layer or a multilayer. The organic photoelectric conversion layer 30 may be, for example, an intrinsic layer (I layer), a p-type layer/I layer, an I layer/n-type layer, a p-type layer/I layer/n-type layer, and a p-type layer/n-type layer.

The intrinsic layer (I layer) may include the p-type semiconductor and the n-type semiconductor in a thickness ratio of about 1:100 to about 100:1. The semiconductors may be included in a thickness ratio ranging from about 1:50 to about 50:1 within the range, for example, about 1:10 to about 10:1, or about 1 to about 1. When the p-type and n-type semiconductors have a composition ratio within the range, an exciton may be effectively produced, and a pn junction may be effectively formed.

The p-type layer may include the p-type semiconductor, and the n-type layer may include the n-type semiconductor.

The organic photoelectric conversion layer 30 may have a thickness of about 1 nanometer to about 500 nanometers. Within the range, the organic photoelectric conversion layer 30 may have a thickness of about 5 nanometers to about 300 nanometers. When the organic photoelectric conversion layer 30 has a thickness within the range, the organic photoelectric conversion layer 30 may effectively absorb light, effectively separate holes from electrons, and deliver them, effectively improving photoelectric conversion efficiency.

The second electrode 20 may be positioned on the organic photoelectric conversion layer 30 and may be a light-transmitting electrode into which light enters. The second electrode 20 may be made of, for example, a transparent conductor (e.g., indium tin oxide (ITO) or indium zinc oxide (IZO)), and the second electrode 20 may be a metal thin layer having a relatively thin thickness of several nanometers or several tens of nanometers or a metal thin layer having a relatively thin thickness of several nanometers to several tens of nanometers doped with a metal oxide. One of the first electrode 10 and the second electrode 20 is an anode and the other is a cathode.

The first electrode 10, the organic photoelectric conversion layer 30, and the second electrode 20 provide an organic photoelectronic device 100, and when light is incident from the second electrode 20 and the organic photoelectric conversion layer 30 adsorbs light in a green wavelength region, excitons may be produced from the inside the organic photoelectronic device 100. The excitons are separated into holes and electrons in the organic photoelectric conversion layer 30, and the separated holes are transported to an anode that is one of the first electrode10 and the second electrode 20, and the separated electrons are transported to the cathode that is the other of the first electrode 10 and the second electrode 20, so as to flow a current. The separated electrons or holes may be collected in the charge storage device 55. Light in other wavelength regions except for a green wavelength region passes the first electrode 110 and may be sensed by the blue photo-sensing device 50B or the red photo-sensing device 50R.

The organic photoelectronic device 100 may be formed on the front of the image sensor and absorb light thereon, and thus increase a light area and bring about relatively high light absorption efficiency.

As shown in FIGS. 7 and 8, the blue photo-sensing device 50B sensing light in a blue wavelength region and the red photo-sensing device 50R sensing light in a red wavelength region may be spaced apart from each other in a horizontal direction. When a nanopattern P1 corresponding to the blue photo-sensing device 50B has the same shape as that of a nanopattern P3 corresponding to the red photo-sensing device 50R, the size d1 of the nanopattern P1 corresponding to the blue photo-sensing device 50B may differ from the size d3 of the nanopattern P3 corresponding to the blue photo-sensing device 50R.

In FIG. 7, the blue photo-sensing device 50B sensing light in a blue wavelength region and the red photo-sensing device 50R sensing light in a red wavelength region are integrated in the semiconductor substrate 110, and the organic photoelectronic device 100 includes the organic photoelectric conversion layer 30 selectively absorbing light in a green wavelength region. However, the organic photoelectronic device 100 is not limited to the above structure shown in FIG. 1. A photo-sensing device sensing light in a blue wavelength region and a photo-sensing device sensing light in a green wavelength region may be integrated in the semiconductor substrate 110, and the organic photoelectronic device 100 may include an organic photoelectric conversion layer 30 selectively absorbing light in a red wavelength region. Alternatively, a photo-sensing device sensing light in a red wavelength region and a photo-sensing device sensing light in a green wavelength region may be integrated in the semiconductor substrate 110, and the organic photoelectronic device 100 may include an organic photoelectric conversion layer selectively absorbing light in a blue wavelength region.

Herein, the red wavelength region may have a maximum absorption wavelength (λₘₐₓ) of greater than about 580 nanometers and less than or equal to about 700 nanometers, the blue wavelength region may have a maximum absorption wavelength (λₘₐₓ) of greater than or equal to about 400 nanometers and less than about 500 nanometers, and the green wavelength region may have a maximum absorption wavelength (λₘₐₓ) of about 500 nanometers to about 580 nanometers.

The image sensor according to example embodiments includes the nanopattern layer having a nanopattern of a given (or alternatively, predetermined) size and thereby color separation characteristics are improved without equipping a separate organic color filter layer, like the above example embodiment illustrated in FIG. 7. In addition, since light in a green wavelength region is selectively reflected toward the organic photoelectric conversion layer 30 due to generation of interference according to introduction of the nanopattern layer 70, a green light absorption rate of the organic photoelectric conversion layer 30 may be further increased.

In the image sensor 2000 of FIGS. 7 and 8, the blue photo-sensing device 50B and the red photo-sensing device 50R are positioned at the same depth from the surface of the semiconductor substrate 110, but are not limited thereto, and the blue photo-sensing device 50B and the red photo-sensing device 50R may be positioned at a substantially different depth from the surface of the semiconductor substrate 110. For example, the red photo-sensing device 50R may be positioned further from the surface of the semiconductor substrate 110 than the blue photo-sensing device 50B.

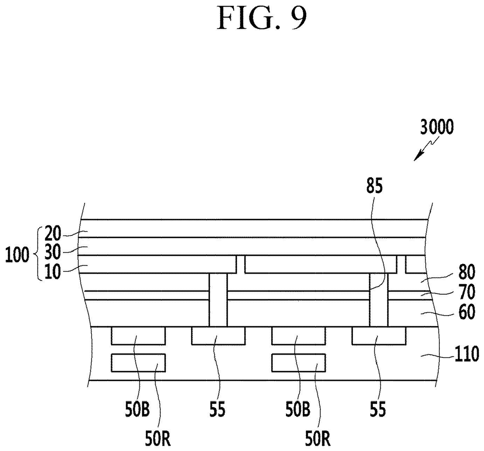

FIG. 9 is a schematic cross-sectional view showing a CMOS image sensor according to example embodiments

Referring to FIG. 9, the image sensor 3000 according to example embodiments includes a semiconductor substrate 110, a nanopattern layer 70 positioned on the semiconductor substrate 110, and the organic photoelectronic device 100 positioned on the nanopattern layer 70, like the example embodiment illustrated in FIG. 8.

The semiconductor substrate 110 may be a silicon substrate, for example, a monocrystalline silicon substrate. The semiconductor substrate 110 is integrated with a blue photo-sensing device 50B, a red photo-sensing device 50R, a charge storage device 55, and a transmission transistor (not shown). The blue photo-sensing device 50B and the red photo-sensing device 50R may be photodiodes.

However, the image sensor 3000 according to example embodiments includes the blue photo-sensing device 50B and red photo-sensing device 50R are stacked with each other, unlike the example embodiment illustrated in FIG. 8. The blue photo-sensing device 50B and the red photo-sensing device 50R are electrically connected with the charge storage device (not shown), and may be transferred by a transmission transistor.

As aforementioned, an organic photoelectronic device selectively absorbing light in a green wavelength region has a stacked structure, and since the red photo-sensing device and the blue photo-sensing device are stacked, the size of an image sensor may be decreased, and thus crosstalk due to thickness increase of the image sensor may be decreased. In addition, as described above, light in a green wavelength region is reflected toward the organic photoelectric conversion layer 30 due to generation of interference according to introduction of the nanopattern layer 70, and thus the green light absorption rate of the organic photoelectric conversion layer 30 may be further increased.

The aforementioned image sensor has a nanopattern layer having a given (or alternatively, predetermined) pattern size on the semiconductor substrate and thus may selectively pass and reflect light in a particular wavelength region, and has relatively high color separation characteristics without having a separate organic color filter layer and may increase a light absorption rate of the organic photoelectric conversion layer, and thus photoelectric efficiency. In addition, an image sensor has a smaller thickness and may secure characteristics of concentrating light without a separate microlens.

The image sensor may be applied to various electronic devices, for example, a mobile phone, a digital camera, and a biosensor, without limitation.

Hereinafter, the present disclosure is illustrated in more detail with reference to examples. However, these are examples, and the present disclosure is not limited thereto.

### Evaluation of Wavelength Selectivity

### Example 1

Wavelength selectivity of an image sensor manufactured by applying a nanopattern layer according to example embodiments is evaluated through an optical simulation.

The optical simulation is calculated in a finite-difference time-domain (FDTD) method by using the Lumerical FDTD Solutions program.

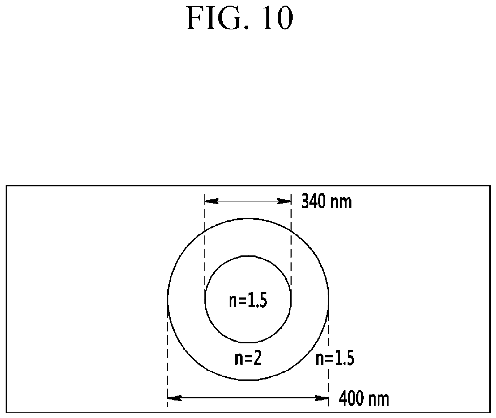

FIG. 10 is a cross-sectional view partially showing a part of the nanopattern layer according to example embodiments.

Referring to FIG. 10, the nanopattern layer according to example embodiments has a circular ring-shaped pattern, an area corresponding to the circular ring is formed of a dielectric substance having a refractive index (n)=2, while the rest of an area except for the ring is formed of a dielectric substance having a refractive index (n)=1.5, and an outer ring of the circular ring has a diameter of 400 nm, while an inner ring of the circular ring has a diameter of 340 nm.

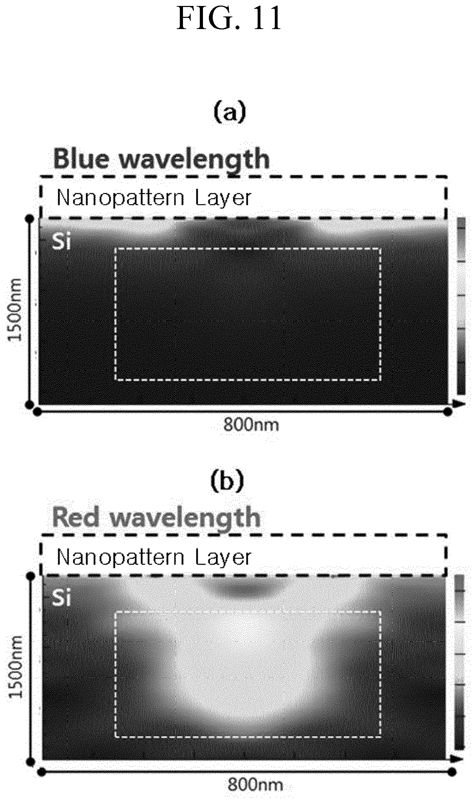

FIGS. 11(a) and 11(b) show a blue electric field distribution chart (FIG. 11(a)) and a red electric field distribution chart (FIG. 11(b)) in a silicon (Si) photodiode manufactured by introducing the nanopattern layer according to example embodiments thereon. Referring to FIGS. 11(a) and (b), a horizontal axis indicates pixel size (800 nm) of the silicon (Si) photodiode, while a vertical axis indicates thickness (1500 nm) of the silicon (Si) photodiode, and the nanopattern layer shown in FIG. 10 is positioned on the silicon (Si) photodiode.

Referring to FIGS. 11(a) and (b), the silicon (Si) photodiode including the nanopattern layer having a nanopattern of a given (or alternatively, predetermined) size thereon turns out to have wavelength selectivity about a blue wavelength region without having an organic color filter.

### Example 2

Wavelength selectivity of an image sensor manufactured by applying a nanopattern layer according to example embodiments is evaluated through an optical simulation.

The optical simulation is performed by using the same program used in Example 1.

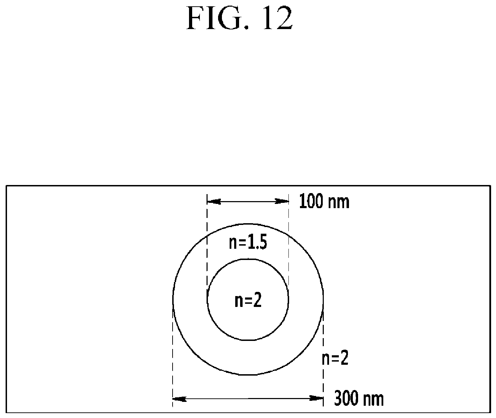

FIG. 12 is a cross-sectional view showing a part of the nanopattern layer according to example embodiments.

Referring to FIG. 12, the nanopattern layer according to example embodiments has a circular ring-shaped pattern, an area corresponding to the circular ring is formed of a dielectric substance having a refractive index (n)=1.5, while the rest of an area except for the ring is formed of a dielectric substance having a refractive index (n)=2, and an outer ring of the circular ring has a diameter of 300 nm, while an inner ring of the circular ring has a diameter of 100 nm.

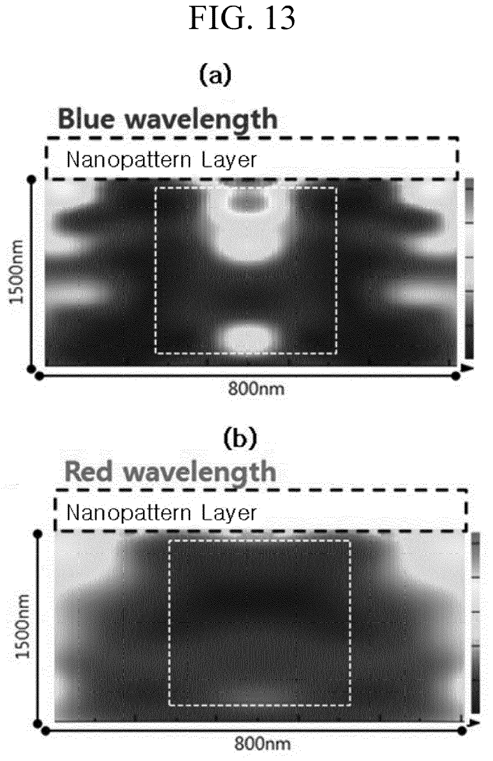

FIGS. 13(a) and 13(b) shows a blue electric field distribution chart (FIG. 13(a)) and a red electric field distribution chart (FIG. 13(b)) in a silicon (Si) photodiode manufactured by introducing the nanopattern layer according to example embodiments thereon. Referring to FIGS. 13(a) and 13(b), a horizontal axis indicates pixel size (800 nm) of the silicon (Si) photodiode, while a vertical axis indicates thickness (1500 nm) of the silicon (Si) photodiode, and the nanopattern layer shown in FIG. 12 is positioned on the silicon (Si) photodiode.

Referring to FIGS. 13(a) and 13(b), the silicon (Si) photodiode including the nanopattern layer having a nanopattern of a given (or alternatively, predetermined) size thereon turns out to have wavelength selectivity about a blue wavelength region without having an organic color filter.

## Claims

1. An image sensor (1000, 2000, 3000), comprising:
a semiconductor substrate (110) integrated with a plurality of photo-sensing devices (50) spaced apart from each other in a horizontal direction; and
a nanopattern layer (70) on the semiconductor substrate, the nanopattern layer including at least two types of dielectric substances having different refractive indexes from each other and having a plurality of nanopatterns (P), the two types of dielectric substances having a refractive index difference of greater than or equal to 0.2, the two types of dielectric substances being formed in separate regions from each other, and the nanopatterns being defined at the interface between the two types of dielectric substances,
wherein a single nanopattern of the plurality of nanopatterns corresponds to a single photo-sensing device of the plurality of photo-sensing devices;
wherein each nanopattern of the plurality of nanopatterns (P) has a size greater than or equal to 1 nanometer to less than 1 micrometer; and
wherein the size of the nanopattern is the longest horizontal width that the nanopattern has in cross-section when the nanopattern layer is horizontally cut,
and **characterized in that** the single nanopattern (P) transmits light in a wavelength region only onto the single photo-sensing device corresponding thereto.

2. The image sensor of claim 1, wherein the single nanopattern (P) has a size greater than or equal to 100 nanometers and less than 1 micrometer.

3. The image sensor of any preceding claim, wherein the nanopattern layer has a thickness of less than 1 micrometer.

4. The image sensor of any preceding claim, further comprising:
an organic photoelectronic device (100) on the nanopattern layer, the organic photoelectronic device including,
a first electrode (10) and a second electrode (20) facing each other, and
an organic photoelectric conversion layer (30) between the first electrode and the second electrode.

5. The image sensor of claim 4, wherein the plurality of photo-sensing device integrated in the semiconductor substrate include a first photo-sensing device sensing light in a first wavelength region and a second photo-sensing device sensing light in a second wavelength region different from the first wavelength region

6. The image sensor of claim 5, wherein
the size of the nanopattern corresponding to the first photo-sensing device is different from the size of the nanopattern corresponding to the second photo-sensing device,
and optionally wherein
the nanopattern corresponding to the first photo-sensing device selectively transmits light in the first wavelength region, and
the nanopattern corresponding to the second photo-sensing device selectively transmits light in the second wavelength region.

7. The image sensor of claim 5, wherein the organic photoelectric conversion layer (30) absorbs light in a third wavelength region different from the first wavelength region and the second wavelength region.
and optionally wherein the plurality of nanopatterns selectively reflects light in the third wavelength region to the organic photoelectric conversion layer.

8. The image sensor of claim 7, wherein
the first wavelength region is a blue wavelength region,
the second wavelength region is a red wavelength region, and
the third wavelength region is a green wavelength region wherein
the red wavelength region has a maximum absorption wavelength (λₘₐₓ) of greater than 580 nanometers and less than or equal to 700 nanometers,
the blue wavelength region has a maximum absorption wavelength (λₘₐₓ) of greater than or equal to 400 nanometers and less than 500 nanometers, and
the green wavelength region has a maximum absorption wavelength (λₘₐₓ) of 500 nanometers to 580 nanometers.

9. The image sensor of any of claims 5 to 8, wherein the first photo-sensing device (50B,50G,50R) and the second photo-sensing device (50B,50G,50R) are positioned at different depths from the surface of the semiconductor substrate,
and optionally wherein:
the first photo-sensing device (50G,50R) senses light in a longer wavelength region than the second photo-sensing device (50B,50G), and
the first photo-sensing device is further from the surface of the semiconductor substrate than the second photo-sensing device.

10. The image sensor of any of claims 4 to 9, wherein
the organic photoelectric conversion layer (30) includes a p-type semiconductor and an n-type semiconductor, and
the p-type semiconductor and the n-type semiconductor form a pn junction.

11. An electronic device comprising the image sensor of claim 1.

## Patentansprüche

1. Bildsensor (1000, 2000, 3000), umfassend:
ein Halbleitersubstrat (110), das mit einer Vielzahl von lichtempfindlichen Vorrichtungen (50) integriert ist, die in einer horizontalen Richtung voneinander beabstandet sind; und
eine Nanostrukturschicht (70) auf dem Halbleitersubstrat, wobei die Nanostrukturschicht mindestens zwei Arten dielektrischer Substanzen mit voneinander verschiedenen Brechungsindizes beinhaltet und eine Vielzahl von Nanostrukturen (P) aufweist, wobei die zwei Arten dielektrischer Substanzen einen Brechungsindexdifferenz von größer als oder gleich 0,2 aufweisen, die zwei Arten dielektrischer Substanzen in voneinander separaten Bereichen gebildet sind und die Nanostrukturen an der Grenzfläche zwischen den zwei Arten dielektrischer Substanzen definiert sind,
wobei eine einzelne Nanostruktur der Vielzahl von Nanostrukturen einer einzelnen lichtempfindlichen Vorrichtung der Vielzahl von lichtempfindlichen Vorrichtungen entspricht;
wobei jede Nanostruktur der Vielzahl von Nanostrukturen (P) eine Größe von größer als oder gleich 1 Nanometer bis weniger als 1 Mikrometer aufweist; und
wobei die Größe der Nanostruktur die längste horizontale Breite ist, die in der Nanostruktur im Querschnitt vorliegt, wenn die Nanostrukturschicht horizontal geschnitten wird,
und **dadurch gekennzeichnet, dass** die einzelne Nanostruktur (P) Licht in einem Wellenlängenbereich nur auf die damit korrespondierende einzelne lichtempfindliche Vorrichtung überträgt.

2. Bildsensor nach Anspruch 1, wobei die einzelne Nanostruktur (P) eine Größe von größer als oder gleich 100 Nanometer und weniger als 1 Mikrometer aufweist.

3. Bildsensor nach einem vorhergehenden Anspruch, wobei die Nanostrukturschicht eine Dicke von weniger als 1 Mikrometer aufweist.

4. Bildsensor nach einem vorhergehenden Anspruch, ferner umfassend:
eine organische photoelektronische Vorrichtung (100) auf der Nanostrukturschicht, wobei die organische photoelektronische Vorrichtung beinhaltet,
eine erste Elektrode (10) und eine zweite Elektrode (20), die einander zugewandt sind, und
eine organische photoelektrische Umwandlungsschicht (30) zwischen der ersten Elektrode und der zweiten Elektrode.

5. Bildsensor nach Anspruch 4, wobei die Vielzahl von lichtempfindlichen Vorrichtungen, die in das Halbleitersubstrat integriert sind, eine erste lichtempfindliche Vorrichtung, die Licht in einem ersten Wellenlängenbereich erfasst, und eine zweite lichtempfindliche Vorrichtung, die Licht in einem sich von dem ersten Wellenlängenbereich unterscheidenden zweiten Wellenlängenbereich erfasst, beinhalten.

6. Bildsensor nach Anspruch 5, wobei
die Größe der Nanostruktur, die der ersten lichtempfindlichen Vorrichtung entspricht, sich von der Größe der Nanostruktur, die der zweiten lichtempfindlichen Vorrichtung entspricht, unterscheidet,
und wahlweise, wobei
die Nanostruktur, die der ersten lichtempfindlichen Vorrichtung entspricht, Licht in dem ersten Wellenlängenbereich selektiv überträgt, und die Nanostruktur, die der zweiten lichtempfindlichen Vorrichtung entspricht, Licht in dem zweiten Wellenlängenbereich selektiv überträgt.

7. Bildsensor nach Anspruch 5, wobei die organische photoelektrische Umwandlungsschicht (30) Licht in einem dritten Wellenlängenbereich, der sich von dem ersten Wellenlängenbereich und dem zweiten Wellenlängenbereich unterscheidet, absorbiert
und wahlweise, wobei die Vielzahl von Nanostrukturen Licht in dem dritten Wellenlängenbereich selektiv zu der organischen photoelektrischen Umwandlungsschicht reflektiert.

8. Bildsensor nach Anspruch 7, wobei
der erste Wellenlängenbereich ein blauer Wellenlängenbereich ist,
der zweite Wellenlängenbereich ein roter Wellenlängenbereich ist, und
der dritte Wellenlängenbereich ein grüner Wellenlängenbereich ist, wobei
der rote Wellenlängenbereich eine maximale Absorptionswellenlänge (λₘₐₓ) von größer als 580 Nanometer und weniger als oder gleich 700 Nanometer aufweist,
der blaue Wellenlängenbereich eine maximale Absorptionswellenlänge (λₘₐₓ) von größer als oder gleich 400 Nanometer und weniger als 500 Nanometer aufweist, und
der grüne Wellenlängenbereich eine maximale Absorptionswellenlänge (λₘₐₓ) von 500 Nanometer bis 580 Nanometer aufweist.

9. Bildsensor nach einem der Ansprüche 5 bis 8, wobei die erste lichtempfindliche Vorrichtung (50B,50G,50R) und die zweite lichtempfindliche Vorrichtung (50B,50G,50R) in verschiedenen Tiefen von der Oberfläche des Halbleitersubstrats aus positioniert sind,
und wahlweise, wobei:
die erste lichtempfindliche Vorrichtung (50G,50R) Licht in einem längeren Wellenlängenbereich als die zweite lichtempfindliche Vorrichtung (50B,50G) erfasst, und
die erste lichtempfindliche Vorrichtung weiter weg von der Oberfläche des Halbleitersubstrats ist als die zweite lichtempfindliche Vorrichtung.

10. Bildsensor nach einem der Ansprüche 4 bis 9, wobei die organische photoelektrische Umwandlungsschicht (30) einen p-Typ-Halbleiter und einen n-Typ-Halbleiter beinhaltet, und
der p-Typ-Halbleiter und der n-Typ-Halbleiter einen pn-Übergang bilden.

11. Elektronische Vorrichtung, umfassend den Bildsensor nach Anspruch 1.

## Revendications

1. Capteur d'image (1000, 2000, 3 000), comprenant :
un substrat semi-conducteur (110) intégré à une pluralité de dispositifs de photodétection (50) espacés les uns des autres dans une direction horizontale ; et
une couche à nanomotifs (70) sur le substrat semi-conducteur, la couche à nanomotifs comprenant au moins deux types de substances diélectriques ayant des indices de réfraction différents les uns des autres et ayant une pluralité de nanomotifs (P), les deux types de substances diélectriques ayant une différence d'indice de réfraction supérieure ou égale à 0,2, les deux types de substances diélectriques étant formés dans des régions distinctes les unes des autres, et les nanomotifs étant définis à l'interface entre les deux types de substances diélectriques, dans lequel un nanomotif unique de la pluralité de nanomotifs correspond à un dispositif de photodétection unique de la pluralité de dispositifs de photodétection ;
dans lequel chaque nanomotif de la pluralité de nanomotifs (P) a une taille supérieure ou égale à 1 nanomètre et inférieure à 1 micromètre ; et
dans lequel la taille du nanomotif est la plus longue largeur horizontale que le nanomotif a en coupe transversale lorsque la couche à nanomotifs est coupée horizontalement, et **caractérisé en ce que** le nanomotif (P) unique transmet la lumière dans une région de longueur d'onde uniquement sur le dispositif de photodétection unique correspondant à celui-ci.

2. Capteur d'image selon la revendication 1, dans lequel le nanomotif (P) unique a une taille supérieure ou égale à 100 nanomètres et inférieure à 1 micromètre.

3. Capteur d'image selon l'une quelconque des revendications précédentes, dans lequel la couche à nanomotifs a une épaisseur inférieure à 1 micromètre.

4. Capteur d'image selon l'une quelconque des revendications précédentes, comprenant en outre :
un dispositif photoélectronique organique (100) sur la couche à nanomotifs, le dispositif photoélectronique organique comprenant, une première électrode (10) et une seconde électrode (20) se faisant face, et une couche de conversion photoélectrique organique (30) entre la première électrode et le deuxième électrode.

5. Capteur d'image selon la revendication 4, dans lequel la pluralité de dispositifs de photodétection intégrés dans le substrat semi-conducteur comprennent un premier dispositif de photodétection détectant la lumière dans une première région de longueur d'onde et un deuxième dispositif de photodétection détectant la lumière dans une deuxième région de longueur d'onde différente de la première région de longueur d'onde.

6. Capteur d'image selon la revendication 5, dans lequel la taille du nanomotif correspondant au premier dispositif de photodétection est différente de la taille du nanomotif correspondant au deuxième dispositif de photodétection, et facultativement dans lequel le nanomotif correspondant au premier dispositif de photodétection transmet sélectivement la lumière dans la première région de longueur d'onde, et le nanomotif correspondant au deuxième dispositif de photodétection transmet sélectivement la lumière dans la deuxième région de longueur d'onde.

7. Capteur d'image selon la revendication 5, dans lequel la couche de conversion photoélectrique organique (30) absorbe la lumière dans une troisième région de longueur d'onde différente de la première région de longueur d'onde et de la deuxième région de longueur d'onde,
et facultativement, dans lequel la pluralité de nanomotifs réfléchissent sélectivement la lumière dans la troisième région de longueur d'onde vers la couche de conversion photoélectrique organique.

8. Capteur d'image selon la revendication 7, dans lequel la première région de longueur d'onde est une région de longueur d'onde bleue, la deuxième région de longueur d'onde est une région de longueur d'onde rouge, et la troisième région de longueur d'onde est une région de longueur d'onde verte dans lequel la région de longueur d'onde rouge a une longueur d'onde d'absorption maximale (λₘₐₓ) supérieure à 580 nanomètres et inférieure ou égale à 700 nanomètres, la région de longueur d'onde bleue a une longueur d'onde d'absorption maximale (λₘₐₓ) supérieure ou égale à 400 nanomètres et inférieure à 500 nanomètres, et la région de longueur d'onde verte a une longueur d'onde d'absorption maximale (λₘₐₓ) de 500 nanomètres à 580 nanomètres.

9. Capteur d'image selon l'une quelconque des revendications 5 à 8, dans lequel le premier dispositif de photodétection (50B, 50G, 50R) et le deuxième dispositif de photodétection (50B, 50G, 50R) sont positionnés à des profondeurs différentes depuis la surface du substrat semi-conducteur, et éventuellement dans lequel :
le premier dispositif de photodétection (50G, 50R) détecte la lumière dans une région de longueur d'onde plus longue que le second dispositif de photodétection (50B, 50G), et le premier dispositif de photodétection est plus éloigné de la surface du substrat semi-conducteur que le second dispositif de photodétection.

10. Capteur d'image selon l'une quelconque des revendications 4 à 9, dans lequel la couche de conversion photoélectrique organique (30) comprend un semi-conducteur de type p et un semi-conducteur de type n, et le semi-conducteur de type p et le semi-conducteur de type n forment une jonction pn.

11. Dispositif électronique comprenant le capteur d'image selon la revendication 1.
